# EUROPEAN PATENT SPECIFICATION

(11) **EP 2 322 692 B1**
(45) Date of publication and mention of the grant of the patent: **12.10.2016**
(21) Application number: 09813013.1
(22) Date of filing: 25.08.2009
(51) Int. Cl.: C23F 1/38, C23F 1/44, C11D 11/00, C23G 1/20

(54) **ETCHANT FOR TITANIUM-BASED METAL, TUNGSTEN-BASED METAL, TITANIUM-TUNGSTEN-BASED METAL OR NITRIDES THEREOF**
ÄTZMITTEL FÜR METALLE AUF TITANBASIS, METALLE AUF TUNGSTENBASIS, METALLE AUF TITAN-TUNGSTEN-BASIS ODER NITRIDE DAVON
AGENT DE GRAVURE POUR MÉTAL À BASE DE TITANE, MÉTAL À BASE DE TUNGSTÈNE, MÉTAL À BASE DE TITANE ET DE TUNGSTÈNE OU NITRURES DE CEUX-CI

(30) Priority: 09.09.2008 JP 2008231325
(43) Date of publication of application: 18.05.2011
(73) Proprietor: Showa Denko K.K., Tokyo 105-8518 (JP)
(72) Inventor: SATO, Hironosuke, Shunan-shi Yamaguchi 746-0006 (JP); SAITO, Yasuo, Shunan-shi Yamaguchi 746-0006 (JP)
(74) Representative: Strehl Schübel-Hopf & Partner
(86) International application number: PCT/JP2009/065136
(87) International publication number: WO 2010/029867

(56) References cited:
- EP-A1- 0 292 057
- EP-A1- 1 826 260
- DE-C1- 4 110 595
- JP-A- 6 310 492
- JP-A- 63 305 518
- JP-A- 2005 146 358
- JP-T- 2008 536 312
- US-A- 4 554 050
- US-A- 5 462 638
- US-A- 5 759 437

## Description

### Technical Field

The present invention relates to an etching solution for titanium-based metals, tungsten-based metals, titanium/tungsten-based metals, or their nitrides. In particular, the invention relates to an etching solution with excellent selective etching properties for titanium-based metals, tungsten-based metals, titanium/tungsten-based metals or their nitrides, with respect to metals other than titanium-based metals, tungsten-based metals and titanium/tungsten-based metals.

### Background Art

Titanium metal (Ti), titanium nitride (TiN) and titanium alloys, as titanium-based metals, are utilized for semiconductor devices, liquid crystal displays, MEMS (Micro Electro Mechanical Systems), printed wiring boards and the like, and as ground layers and cap layers for precious metal, aluminum (Al) and copper (Cu) wiring. In semiconductor devices, they are also used as barrier metals and gate metals.

Methods of treatment with hydrofluoric acid/nitric acid mixtures and hydrogen peroxide/hydrofluoric acid mixtures are known for common titanium-based metal etching, but because these contain hydrofluoric acid, they introduce the drawback of corrosion of silicon substrates and glass substrates as well. Another problem is that metals in the devices that are prone to corrosion, such as Al wirings, also undergo etching.

Hydrogen peroxide/ammonia/EDTA (ethylenediaminetetraacetic acid) mixtures and hydrogen peroxide/phosphate mixtures have been disclosed as means of overcoming the drawbacks of such solutions (PTL 1 and 2). However, these have low titanium-based metal etching rates, while decomposition of hydrogen peroxide is rapid, making stable etching impossible, and therefore etching solutions comprising hydrogen peroxide/phosphoric acid/ammonia mixtures have been proposed as modifications of such solutions (PTL 3). With such etching solutions, however, the etching rate is improved but intense foaming of the etching solution causes attachment of bubbles onto the substrate surface, and etching does not proceed at the bubble-attached parts. Another problem is the low etching rate due to foaming and decomposition of the hydrogen peroxide water. Such mixtures are used with adjustment to a designated pH with ammonia, but even slight differences in pH alter the etching rate and foaming condition, and can be problematic from the viewpoint of stability of the etching conditions.

There is also disclosed a semiconductor cleaning solution comprising an organic acid ammonium salt in hydrogen peroxide/ammonia/water, as a hydrogen peroxide-containing cleaning solution (PTL 4). However, the semiconductor cleaning solution is a cleaning solution that removes extraneous contaminant such as fine particles adhering to the substrate in the semiconductor production process, and although it is stated that the difference in etching rates between doped oxide films and non-doped oxide films is minimal, nothing at all is mentioned regarding etching of titanium-based metals. In PTL 5 there is disclosed a composition for removal of resist residue, comprising hydrogen peroxide/carboxylate/water. The purpose of the composition is removal of resist residue after ashing of the resist, and it is not intended for etching of titanium-based metals.

Tungsten or tungsten alloys are used for gate electrodes of thin-film transistors, wirings, barrier layers, or for filling of contact holes or via holes in liquid crystal displays and semiconductor devices. They are also used as tungsten heaters in MEMS (Micro Electro Mechanical Systems).

Tungsten or tungsten alloys are usually formed into films by CVD or sputtering. When films are formed by these methods, however, they also adhere on substrate (wafer) back sides, on substrate (wafer) edges, on the external walls of film-forming apparatuses and in exhaust pipes, in addition to the actual element-forming areas in the semiconductor devices, and they peel off and cause to produce extraneous material on the element-forming areas. This is sometimes countered by removing the unwanted film with an etching solution. In addition to measures against extraneous material, it is preferable to employ highly productive wet etching instead of dry etching for tungsten or tungsten alloys in the production steps of semiconductor devices, liquid crystal display apparatuses and MEMS devices. Wet etching is particularly suitable for liquid crystal displays and MEMS devices which do not require the same level of working precision as semiconductor devices.

Mixtures of hydrofluoric acid and nitric acid are widely known as etching solutions and removing solutions for tungsten-based metals (Non-PTL 1, for example), but these are not preferred because silicon substrates or silicon dioxide films and glass substrates also dissolve. Another problem is that metals that are prone to corrosion, such as Al wirings, in the devices are also etched. Hydrogen peroxide water-based etching solutions are also known from PTL 6-9, for example, and PTL 9 summarizes in detail the problems of conventional hydrogen peroxide-based etching solutions. According to this publication, the etching speed is slow and the pH varies as tungsten dissolves, resulting in a variable etching rate and poor etching selectivity. In addition, it is stated that dissolution of tungsten drastically increases the hydrogen peroxide decomposition rate. A mixture of azole added to hydrogen peroxide is disclosed as a solution for this problem (PTL 8), but inhibition of hydrogen peroxide decomposition is still insufficient, and the etching rate is not stable. Thus, no practical hydrogen peroxide water-based etching solution yet exists which has a stable tungsten etching rate, high tungsten etching selectivity and a long solution life. EP 1826 260 A1, EP 0292 057 A1 US 4554 050 A, US 5462 638A disclose selective etching solution for Ti, W, Ti-W or their nitrides on a glass or silicon base material, which comprise H₂O₂, an organic acid salt and water.

### Prior Art Reference

### Patent literature

PTL 1 Japanese Unexamined Patent Publication No. 08-013166
PTL 2 Japanese Unexamined Patent Publication No. 2000-311891
PTL 3 Japanese Unexamined Patent Publication No. 2005-146358
PTL 4 Japanese Unexamined Patent Publication No. 10-284452
PTL 5 Japanese Unexamined Patent Publication No. 2005-183525
PTL 6 Japanese Unexamined Patent Publication SHO No. 62-143422
PTL 7 Japanese Unexamined Patent Publication No. 8-250462 PTL 8 Japanese Unexamined Patent Publication No. 2002-53984
PTL 9 Japanese Unexamined Patent Publication No. 2004-31791

### Non-patent literature

Non-PTL 1: Sakamoto, M., ed., Shima, K., publ., "Semiconductor Production Process Materials and Chemicals", September 30, 2006, 1st Edition, p.144.

### Summary of the invention

### Problems to be Solved by the Invention

The invention, which overcomes the problems mentioned above, provides an etching solution for titanium-based metals, tungsten-based metals, titanium/tungsten-based metals or their nitrides, which reduces non-uniform etching of targets to be etched and has a stable etching rate, by minimizing foaming of the etching solution during etching. In addition, it provides an etching solution with no corrosion of substrates and with excellent selective etching properties for titanium-based metals, tungsten-based metals, titanium/tungsten-based metals or their nitrides, with respect to metals other than titanium-based metals, tungsten-based metals and titanium/tungsten-based metals.

### Means for Solving the Problems

As a result of much diligent research directed toward solving the aforementioned problems, the present inventors have found that using an aqueous solution as defined in claim 1 presently on file can minimize foaming of the etching solution and reduce non-uniform etching of targets to be etched, and can stabilize the etching rate. It was further found that using an etching solution as defined in claim 1 presently on file allows selective etching of titanium-based metals, tungsten-based metals, titanium/tungsten-based metals or their nitrides, without etching of other metals such as nickel, copper or aluminum or base materials (glass, silicon, silicon oxide, silicon nitride), and the present invention has been completed upon this finding.

Specifically, the invention comprises the following aspects, for example.
[1] An etching solution for titanium-based metals, tungsten-based metals, titanium/tungsten-based metals or their nitrides, which comprises 15-35 mass% hydrogen peroxide, 0.1-15 mass% of an organic acid salt, and water, wherein the organic acid salt is an ammonium of citric acid.
[2] An etching solution for titanium-based metals, tungsten-based metals, titanium/tungsten-based metals or their nitrides, which consists of 15-35 mass% hydrogen peroxide, 0.1-15 mass% of an organic acid salt, and water, wherein the organic acid salt is an ammonium salt of citric acid.
[3] An etching solution for titanium-based metals, tungsten-based metals, titanium/tungsten-based metals or their nitrides, according to [1], which further comprises 0.005-4.5 mass% ammonia.
[4] An etching solution for titanium-based metals, tungsten-based metals, titanium/tungsten-based metals or their nitrides, according to [4], wherein the ammonium salt of citric acid is at least one selected from among diammonium hydrogen citrate, triammonium citrate.
[5] An etching solution for titanium-based metals, tungsten-based metals, titanium/tungsten-based metals or their nitrides, according to any one of [1] to [4], wherein the ratio of the etching rate for titanium-based metals or their nitrides to that for Al, Ni, Cu, Cr, Ru, Ta, Si or alloys composed mainly of these elements, is at least 20.
[6] An etching solution for titanium-based metals, tungsten-based metals, titanium/tungsten-based metals or their nitrides, according to any one of [1] to [4], wherein the ratio of the etching rate for titanium-based metals or their nitrides to that for glass, silicon, silicon oxide or silicon nitride, is at least 20.
[7] A method for producing an electronic device, which comprises a step of etching a titanium-based metal, tungsten-based metal, titanium/tungsten-based metal or a nitride thereof using an etching solution according to any one of [1] to [6].

### Effect of the Invention

The etching solution as defined in claim 1 presently on file has an excellent selective etching property for titanium-based metals, tungsten-based metals, titanium/tungsten-based metals or their nitrides, with respect to metals other than titanium-based metals, tungsten-based metals and titanium/tungsten-based metals, or base materials (glass, silicon, silicon oxide), as well as little foaming, and therefore using the etching solution of claim 1 presently on file allows uniform etching to be accomplished for titanium-based metals, tungsten-based metals, titanium/tungsten-based metals or their nitrides.

### Brief Description of the Drawings

Fig. 1 is a graph showing the change in titanium etching rate with time for etching solutions having the compositions of Example 1 and Comparative Example 30.
Fig. 2 is a photograph showing the foamed state of a Ti film-attached sample piece when dipped in the etching solution of Example 1.
Fig. 3 is a photograph showing the foamed state of a Ti film-attached sample piece when dipped in the etching solution of Comparative Example 30.
Fig. 4 is a graph showing the change in titanium/tungsten (TiW) etching rate with time for etching solutions having the compositions of Example 12 and Comparative Example 28.

### Modes for Carrying Out the Invention

The invention will now be explained in greater detail.

The hydrogen peroxide is present in the etching solution at 15-35 mass% and more preferably 20-35 mass%. If the hydrogen peroxide concentration is lower than 10 mass%, the etching rate for titanium, tungsten or titanium/tungsten alloys will be reduced, making it impractical. If the hydrogen peroxide concentration is higher than 40 mass%, on the other hand, more hydrogen peroxide will decompose, likewise making it impractical. The ammonium salt of citric acid is present in the etching solution at 0.1-15 mass%, more preferably 1-10 mass% and even more preferably 3-8 mass%. If the ammonium salt of citric acid concentration is lower than 0.1 mass%, the etching rate will be reduced, making it impractical. If the concentration is higher than 15 mass%, there will be no significant increase in the etching rate.

The citric acid ammonium salt may be used as the citric acid ammonium salt itself, or it may be used as the reaction product of the citric acid and ammonia in the etching solution, without any particular restrictions.

Ammonia may be added as necessary to increase the etching rate of the titanium-based metal, tungsten-based metal, titanium/tungsten-based metal or its nitrides. When ammonia is added, the concentration in the etching solution is in the range of 0.005-4.5 mass%, more preferably 0.05-2 mass% and even more preferably 0.1-0.5 mass%. If the ammonia concentration is higher than 4.5 mass%, the etching rate for titanium-based metals, tungsten-based metals or their nitrides will increase, but metals in the device that are prone to corrosion by alkalis, such as Al, will also be etched, and this is therefore undesirable.

The etching solution as defined in claim 1 or claim 2 presently on file has little foaming during etching of titanium-based metals, tungsten-based metals, titanium/tungsten-based metals or their nitrides, and it therefore allows uniform etching. The etching solution of claim 1 or claim 2 presently on file is superior in that it has a low etching rate for metals other than titanium-based metals, tungsten-based metals and titanium/tungsten-based metals, or base materials (glass, silicon, silicon oxide, silicon nitride), and the selective etching property for titanium-based metals, tungsten-based metals, titanium/tungsten-based metals or their nitrides (the ratio of the etching rate for titanium-based metals, tungsten-based metals or their nitrides with respect to the etching rate for metals other than titanium-based metals and tungsten-based metals or base materials (glass, silicon, silicon oxide, silicon nitride)) is at least 20. The etching solution of claim 1 presently on file also contain components other than those mentioned above, such as moistening agents, surfactants, coloring agents, foam inhibitors and organic solvents, in ranges that do not affect the etching property.

The term "titanium-based metal" as used herein means titanium metal (Ti), or an alloy comprising titanium as the main component (at least 70 mass%). A titanium-based metal nitride means a nitride of titanium metal or a titanium alloy, of which titanium nitride is a typical example. A specific example of a titanium alloy is titanium silicide (TiSi). Similarly, "tungsten-based metal" means tungsten metal (W) or an alloy comprising tungsten as the main component (at least 70 mass%). A nitride of a tungsten metal is a nitride of tungsten metal or a tungsten alloy, of which tungsten nitride is a typical example. Specific examples of tungsten alloys include molybdenum-tungsten (MoW) and tungsten silicide (WSi).

The term "titanium/tungsten-based metal" as used herein means an alloy including both titanium and tungsten, with a total of at least 70 mass% of both. A nitride of a titanium/tungsten-based metal is a nitride of such a titanium/tungsten alloy.

The method of forming a film of the titanium-based metal, tungsten-based metal or titanium/tungsten-based metal on the substrate is not particularly restricted, and any method such as CVD, sputtering or vapor deposition may be used, while the film-forming conditions also are not restricted. A metal other than a titanium-based metal, tungsten-based metal or titanium/tungsten-based metal, as used herein, is Al, Ni, Cu, Cr, Ru, Ta, Si or an alloy comprising any of these elements as the main component (70 mass% or greater) (or a total of 70 mass% or greater when it contains more than one element), and it may contain the other elements.

There are no particular restrictions on the device employing the titanium-based metal, tungsten-based metal, titanium/tungsten-based metal or its nitride, and it may be used in general electronic devices. An electronic device in this case is a liquid crystal display, semiconductor device, MEMS device, printed wiring board, organic EL display, field emission display, electronic paper, plasma display, or the like. The term "etching" as used herein refers to a process utilizing the etching phenomenon, and it naturally includes patterning of titanium-based metals, tungsten-based metals and titanium/tungsten-based metals, as well as purposes of cleaning off of titanium-based metal, tungsten-based metal or titanium/tungsten-based metal residues. Thus, the electronic device may further include electronic derices of which production process has a step of dissolving off of the entirety of the titanium-based metal, tungsten-based metal or titanium/tungsten-based metal by an etching solution, even if no titanium, tungsten or titanium/tungsten alloy remains on the final product.

Treatment of a titanium-based metal, tungsten-based metal or titanium/tungsten-based metal, or a nitride thereof, with an etching solution according to the invention will usually be accomplished by a dipping method, but other methods such as spraying or spin etching may be used for the treatment. The conditions for treatment by dipping cannot be specified for all cases since they will differ depending on the hydrogen peroxide concentration, the organic acid ammonium salt type and content, and the film thickness of the titanium-based metal, tungsten-based metal, titanium/tungsten-based metal or nitride thereof, but generally the treatment temperature will be 20-80°C and more preferably 30-60°C. Such treatment may also be carried out while applying ultrasonic waves.

### Examples

The present invention will now be explained in greater detail based on examples and comparative examples, with the understanding that the invention is not limited to these descriptions.

### Measurement of Ti, W and Al etching rates

Sample substrates having Ti, W and Al films formed by sputtering (film thickness: 50 nm each) of Ti, W or Al on a non-alkaline glass substrate for an LCD (liquid crystal display) were each cut to approximately 0.5 cm square to obtain sample pieces. In a 100 ml beaker there was loaded 20 ml of an etching solution having the composition of each of the examples and comparative examples listed in Table 1 below, and heating was performed to 50°C. One each of the Ti, W, Al film-attached sample pieces was simultaneously loaded into the etching solution, and the time until total disappearance of each sputtering film was visually observed. The same measurement was conducted 3 times, and the average values for the etching rates of Ti, W and Al were calculated. Table 1 summarizes the etching rates for each of the examples and comparative examples. The portion in addition to the constituent components of each etching solution shown in Table 1 is water (ultrapure water). The etching solutions of the examples and comparative examples were each prepared with their compositions, with ultrapure water as necessary, using a specialty product of 35 mass% hydrogen peroxide water by Kishida Chemical Co., Ltd., EL grade 28 mass% ammonia water by Kanto Kagaku Co., Ltd., and a commercially available organic acid ammonium salt.

### Measurement of etching rates for metals other than Ti, W and Al

Ni, Cu, Cr, Ru, Ta, Si film-attached sample pieces were used for measurement in the same manner as measurement of the Ti, W and Al etching rates, except that the sputtering film materials were changed from Ti, W and Al to Ni, Cu, Cr, Ru, Ta and Si, and the etching rates were calculated. Table 2 below shows the results of measurement using etching solutions having the compositions of Examples 1 and comparative examples 2 and 3.

### Measurement of change in Ti etching rate

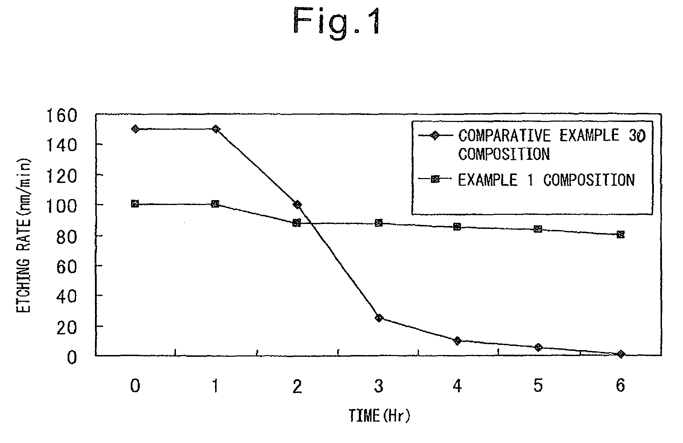

In a 100 ml beaker there was loaded 20 ml of an etching solution having the composition of Example 1 in Table 1, and heating was performed to 50°C. One Ti film-attached sample piece was loaded into the etching solution kept at 50°C. With the sample piece-loading point as the starting point (0 hours), one Ti film-attached sample piece was loaded every hour thereafter while keeping the temperature at 50°C, and the etching rate up to 6 hours thereafter was measured. The method of measuring the etching rate was the same as the method described above. As a comparative example, an experiment was conducted in the same manner using an etching solution comprising 30 mass% hydrogen peroxide, 0.3 mass% phosphoric acid, 0.02 mass% ammonia and 69.68 mass% ultrapure water (Comparative Example 30) The results are shown in Fig. 1.

### Evaluation of foaming condition of etching solution

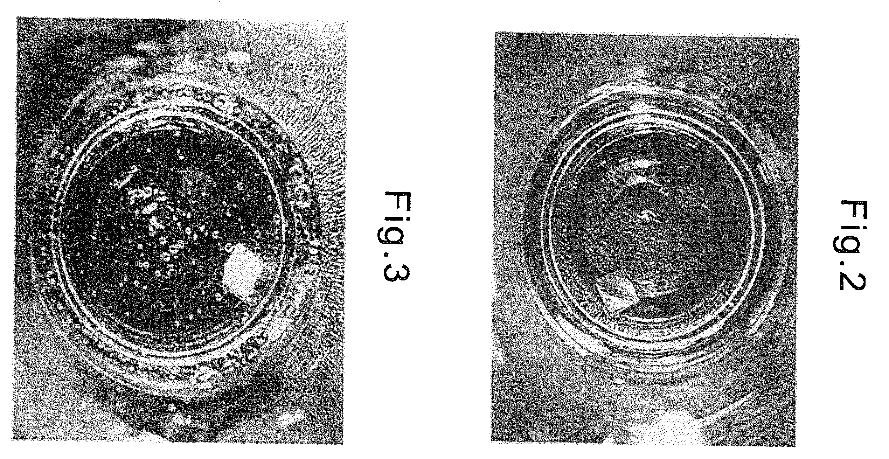

An etching solution having the composition of Example 1 in Table 1 was prepared and kept at a constant temperature of 50°C. A 0.5 cm-square Ti film (50 nm thickness)-attached sample piece was dipped in the etching solution for 1 minute. The foaming condition of the solution at that time was recorded in a photograph. As a comparative example, the foaming condition was evaluated in the same manner using an etching solution comprising 30 mass% hydrogen peroxide, 0.3 mass% phosphoric acid, 0.02 mass% ammonia and 69.68 mass% ultrapure water (Comparative Example 30). The results are shown in Figs. 2 and 3.

### Measurement of change in TiW etching rate

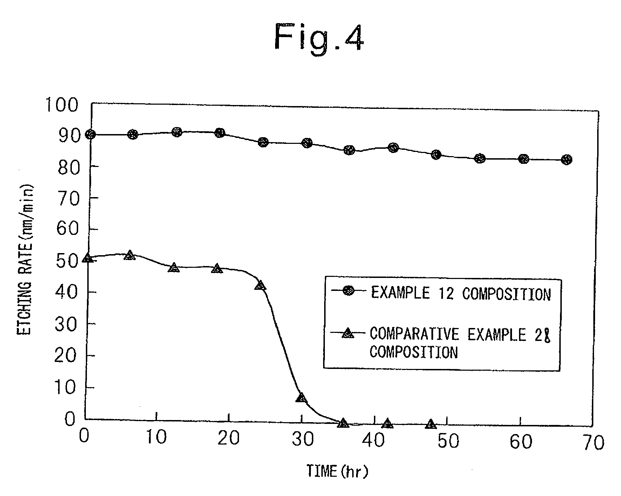

In a 50 ml beaker there was loaded 20 ml of an etching solution having the composition of Example 12 in Table 1, and heating was performed to 45°C. One TiW film-attached silicon wafer piece (approximately 0.5 cm square, TiW film thickness: 200 nm) was loaded into the etching solution kept at 45°C. With the sample piece-loading point as the starting point (0 hours), one TiW film-attached sample piece was loaded every 6 hours thereafter while keeping the temperature at 45°C, and the etching rate was measured up to 66 hours thereafter. The method of measuring the etching rate was the same as the method described above. As a comparative example, an experiment was conducted in the same manner using an etching solution comprising 30 mass% hydrogen peroxide and 70 mass% ultrapure water (Comparative Example 28). The results are shown in Fig. 4. The TiW composition used was 10 mass% Ti, 90 mass% W.

**Table 1**

| | | H₂O₂ (mass%) | NH₃ (mass%) | Organic acid/organic acid salt | | Etching rate (nm/min) | | | Selectivity | |
|---|---|---|---|---|---|---|---|---|---|---|
| | | | | Type | Conc. mass% | Ti | W | Al | Ti/Al | W/Al |
| Invention | 1. | 30 | 0.1 | triammonium citrate | 5.0 | 100 | 375 | <1.0 | >100 | >375 |
| Comparative examples | 2 | 30 | 0.1 | Ammonium formate | 5.0 | 91 | 250 | 1.4 | 65 | 179 |
| | 3 | 30 | 0.1 | Ammonium oxalate | 5.0 | 03 | 333 | 1.1 | 75 | 302 |
| | 1 | 30 | 0.01 | Ammonium acetate | 5.0 | 60 | 600 | <1.0 | >60 | >600 |
| | 5 | 30 | 0.1 | Ammonium tartrate | 5.0 | 61 | 250 | <1.0 | >64 | >250 |
| | 6 | 30 | 0.1 | Ammonium benzoate | 5.0 | 55 | 300 | <1.0 | >55 | >300 |
| | 7 | 30 | 0.1 | Ammonium succinate | 5.0 | 75 | 333 | <1.0 | >75 | >333 |
| | 8 | 20 | 0.1 | Triammonium citrate | 5.0 | 75 | 300 | <1.0 | >75 | >300 |
| Invention | 9 | 20 | 0.5 | Triammonium citrate | 3.0 | 86 | 800 | 3.8 | 23 | 211 |
| | 10 | 30 | 2.0 | Diammonium hydrogen citrate | 5.0 | 250 | 800 | 4.0 | 63 | 200 |
| | 11 | 30 | 0.1 | Triammonium citrate | 15 | 75 | 375 | <1.0 | >7.5 | >375 |
| | 12 | 30 | 0.0 | Triammonium citrate | 5.0 | 55 | 300 | <1.0 | >55 | >300 |
| | 13 | 30 | 0.0 | Ammonium formate | 5.0 | 60 | 215 | <1.0 | >60 | >215 |
| | 14 | 30 | 0.0 | Ammonium oxalate | 5.0 | 33 | 231 | <1.0 | >33 | >231 |
| | 15 | 30 | 0.0 | Ammonium acetate | 5.0 | 60 | 300 | <1.0 | >60 | >300 |
| | 16 | 30 | 0.0 | Ammonium tartrate | 5.0 | 25 | 200 | <1.0 | >25 | >200 |
| Comparative examples | 17 | 30 | 0.0 | Ammonium benzoate | 5.0 | 33 | 200 | <1.0 | >33 | >200 |
| | 18 | 30 | 0.0 | Ammonium succinate | 5.0 | 55 | 300 | <1.0 | >55 | >300 |
| | 19 | 30 | 0.0 | Tripotassium citrate | 5.0 | 50 | 300 | <1.0 | >50 | >300 |
| | 20 | 30 | 0.0 | Trisodium citrate | 5.0 | 50 | 300 | <1.0 | >50 | >300 |
| | 21 | 30 | 0.0 | Sodium oxalate | 5.0 | 23 | 200 | <1.0 | >23 | >200 |
| | 22 | 30 | 0.0 | Sodium acetate | 5.0 | 50 | 300 | <1.0 | >50 | >300 |
| | 23 | 30 | 0.0 | Potassium benzoate | 5.0 | 21 | 200 | <1.0 | >24 | >200 |
| | 24 | 30 | 0.0 | Sodium benzoate | 5.0 | 25 | 200 | <1.0 | >25 | >200 |
| Invention | 25 | 30 | 0.1 | Triammonium citrate | 0.5 | 67 | 210 | <1.0 | >67 | >65 |
| | 26 | 15 | 0.2 | Triammonium citrate | 5.0 | 51 | 180 | <1.0 | >51 | >180 |
| Comp. Examples | 27 | 5 | 0.1 | Triammonium citrate | 5.0 | 15 | 40 | <1.0 | >15 | >40 |
| | 28 | 30 | 0.0 | - | 0.0 | 11 | 150 | <1.0 | >11 | >150 |

**Table 2**

| | Cu | Ni | Ru | Ta | Cr | Si | SᵢO₂ | Si₃N₄ |
|---|---|---|---|---|---|---|---|---|
| Example 1 | <1.0 | <1.0 | <1.0 | <1.0 | <1.0 | <1.0 | <1.0 | <1.0 |
| Comp. Example 2 | <1.0 | <1.0 | <1.0 | <1.0 | <1.0 | <1.0 | <1.0 | <1.0 |
| Comp. Example 3 | <1.0 | <1.0 | <1.0 | <1.0 | <1.0 | <1.0 | <1.0 | <1.0 |

As shown in Table 1, the ratio of the etching rate for Ti and W to the etching rate for Al, using etching solutions having the compositions of Examples 1, 8-AZ,25 was 20 or higher, indicating an excellent selective etching property for Ti and W. The etching rate was generally satisfactory, at greater than 50 nm/min Ti On the other hand, all of the W etching rates were satisfactory at 150 nm/min or greater. In contrast, both the Ti and W etching rates were inadequately low at below 50 nm/min with the etching solution of Comparative Example 27, The Ti etching rate was also inadequately low at below 50 nm/min in Comparative Example 28.

Table 2 shows that the etching solutions of example 1, and comparative examples 2 and 3. had low etching rates for Ni, Cu, Cr, Ru, Ta, Si, SiO₂ and Si₃N₄ as for Al, and therefore had satisfactory selective etching properties for titanium and tungsten with respect to these as well. In addition, Fig. 1. shows that the reduction in titanium etching rate with time was lower with the etching solution of the example 1, and therefore excellent stability was exhibited. With the etching solution of Comparative Example 30, on the other hand, the initial Ti etching rate (150 nm/min) was higher than the etching solution in Example 1., but the change (reduction) in the etching rate with time was large, and therefore the stability was inferior.

When the etching rates were measured for WN, TiW and TiN in the same manner as the composition of Example 1, they were found to be 320 nm/min, 200 nm/min and 120 nm/min, respectively. The TiW composition was 10 mass% and 90 mass% for Ti and W, respectively. The WN and TiN used had the compositions represented by their chemical formulas.

Figs. 2 and 3 show the foaming conditions of the etching solutions when a Ti film-attached sample piece was loaded into each etching solution. The photographs are taken from above the beaker. Considerable foaming of the etching solution is seen in Fig. 3 (the etching solution of Comparative Example 30), but virtually none is seen in Fig. 2 (the etching solution of Examples 1). This demonstrated that an etching solution of the invention is advantageous for uniform etching of titanium-based metals, because it has little foaming during etching.

Fig. 4 shows that the reduction in TiW etching rate with time was lower with the etching solution of the example 12, and therefore excellent stability was exhibited. With the etching solution of Comparative Example 28, on the other hand, the change (reduction) in the TiW etching rate (50 nm/min) with time was large, and therefore the stability was inferior.

### Industrial Applicability

By using an etching solution according to the invention it is possible to accomplish uniform etching of titanium, tungsten and alloys thereof, or their nitrides. In addition, an etching solution of the invention has a low etching rate for other metals such as copper, nickel and aluminum, and for glass, silicon and silicon oxide films, and is therefore useful for production of electronic devices such as semiconductor devices and liquid crystal displays, without damage to substrates and silicon oxide films.

## Claims

1. A selective etching solution for titanium-based metals, tungsten-based metals, titanium/tungsten-based metals or their nitrides on a glass, silicon, silicon oxide or silicon nitride base material, which comprises 15-35 mass% of hydrogen peroxide, 0.1-15 mass% of an organic acid salt, and water, wherein the organic acid salt is an ammonium salt of citric acid.

2. The selective etching solution according to claim 1, which consists of 15-35 mass% of hydrogen peroxide, 0.1-15 mass% of an organic acid salt, and water, wherein the organic acid salt is an ammonium salt of citric acid.

3. The selective etching solution according to claim 1, which further comprises 0.005-4.5 mass% ammonia.

4. The selective etching solution according to any one of claims 1 to 3, wherein the ammonium salt of citric acid is at least one selected from among diammonium hydrogen citrate and triammonium citrate.

5. The selective etching solution according to any one of claims 1 to 4, wherein the ratio of the etching rate for titanium-based metals or their nitrides to that for Al, Ni, Cu, Cr, Ru, Ta, Si or alloys composed mainly of these elements, is at least 20.

6. The selective etching solution according to any one of claims 1 to 4, wherein the ratio of the etching rate for titanium-based metals or their nitrides to that for glass, silicon, silicon oxide or silicon nitride, is at least 20.

7. A method for producing an electronic device, which comprises a step of etching a titanium-based metal, tungsten-based metal, titanium/tungsten-based metal or a nitride thereof using the selective etching solution according to any one of claims 1 to 6.

8. Use of an etching solution according to any one of claims 1 to 6 for selectively etching titanium-based metals, tungsten-based metals, titanium/tungsten-based metals or their nitrides on a glass, silicon, silicon oxide or silicon nitride base material.

## Patentansprüche

1. Selektive Ätzlösung für Metalle auf Titanbasis, Metalle auf Wolframbasis, Metalle auf Titan/Wolframbasis oder ihre Nitride auf einem Glas-, Silizium-, Siliziumoxid- oder Siliziumnitridbasismaterial, welches 15 bis 35 Massen-% Wasserstoffperoxid, 0,1 bis 15 Massen-% eines Salzes einer organischen Säure sowie Wasser enthält, wobei das Salz der organischen Säure ein Ammoniumsalz von Zitronensäure ist.

2. Selektive Ätzlösung nach Anspruch 1, die aus 15 bis 35 Massen-% Wasserstoffperoxid, 0,1 bis 15 Massen-% eines Salzes einer organischen Säure sowie Wasser besteht, wobei das Salz oder organischen Säure ein Ammoniumsalz von Zitronensäure ist.

3. Selektive Ätzlösung nach Anspruch 1, die außerdem 0,005 bis 4,5 Massen-% Ammoniak enthält.

4. Selektive Ätzlösung nach einem der Ansprüche 1 bis 3, wobei das Ammoniumsalz der Zitronensäure mindestens eines ist, das unter Diammoniumhydrogencitrat und Triammoniumcitrat ausgewählt ist.

5. Selektive Ätzlösung nach einem der Ansprüche 1 bis 4, wobei das Verhältnis der Ätzrate für Metalle auf Titanbasis oder ihre Nitride zu derjenigen für Al, Ni, Cu, Cr, Ru, Ta, Si oder Legierungen, die hauptsächlich aus diesen Elementen zusammengesetzt sind, mindestens 20 beträgt.

6. Selektive Ätzlösung nach einem der Ansprüche 1 bis 4, wobei das Verhältnis der Ätzrate für Metalle auf Titanbasis oder ihre Nitride zu derjenigen für Glas, Silizium, Siliziumoxid oder Siliziumnitrid mindestens 20 ist.

7. Verfahren zum Herstellen einer elektronischen Vorrichtung, die eine Stufe umfasst, in der ein Metall auf Titanbasis, ein Metall auf Wolframbasis, ein Metall auf Titan/Wolframbasis oder ein Nitrid davon unter Verwendung der selektiven Ätzlösung nach einem der Ansprüche 1 bis 6 geätzt wird.

8. Verwendung einer Ätzlösung nach einem der Ansprüche 1 bis 6 zum selektiven Ätzen von Metallen auf Titanbasis, Metallen auf Wolframbasis, Metallen auf Titanwolframbasis oder ihren Nitriden auf einem Glas-, Silizium-, Siliziumoxid- oder Siliziumnitridbasismaterial.

## Revendications

1. Solution décapante sélective pour des métaux à base de titane, des métaux à base de tungstène, des métaux à base de titane/tungstène ou leurs nitrures sur un matériau à base de verre, de silicium, d'oxyde de silicium ou de nitrure de silicium, qui comprend 15 à 35 % en poids de peroxyde d'hydrogène, 0,1 à 15 % en poids d'un sel d'acide organique, et de l'eau, dans laquelle le sel d'acide organique est un sel d'ammonium de l'acide citrique.

2. Solution décapante sélective selon la revendication 1, qui est constituée de 15 à 35 % en poids de peroxyde d'hydrogène, de 0,1 à 15 % en poids d'un sel d'acide organique et d'eau, dans laquelle le sel d'acide organique est un sel d'ammonium de l'acide citrique.

3. Solution décapante sélective selon la revendication 1, qui comprend en outre 0,005 à 4,5 % en poids d'ammoniaque.

4. Solution décapante sélective selon l'une quelconque des revendications 1 à 3, dans laquelle le sel d'ammonium de l'acide citrique est au moins un sel choisi parmi l'hydrogénocitrate de di-ammonium et le citrate de tri-ammonium.

5. Solution décapante sélective selon l'une quelconque des revendications 1 à 4, dans laquelle le rapport du taux de décapage pour les métaux à base de titane ou leurs nitrures à celui des Al, Ni, Cu, Cr, Ru, Ta, Si ou des alliages composés principalement de ces éléments est d'au moins 20.

6. Solution décapante sélective selon l'une quelconque des revendications 1 à 4, dans laquelle le rapport du taux de décapage pour les métaux à base de titane ou leurs nitrures à celui du verre, du silicium, de l'oxyde de silicium ou du nitrure de silicium est d'au moins 20.

7. Procédé de production d'un dispositif électronique qui comprend une étape de décapage d'un métal à base de titane, d'un métal à base de tungstène, d'un métal à base de titane/tungstène ou d'un nitrure de ceux-ci, utilisant la solution décapante sélective selon l'une quelconque des revendications 1 à 6.

8. Utilisation d'une solution décapante selon l'une quelconque des revendications 1 à 6, pour le décapage sélectif de métaux à base de titane, de métaux à base de tungstène, de métaux à base de titane/tungstène ou leurs nitrures sur un matériau à base de verre, de silicium, d'oxyde de silicium ou de nitrure de silicium.
